Europäisches Patentamt

European Patent Office

Office européen des brevets

(19)

(11) Publication number:  **0 197 707**

**A2**

(12)          **EUROPEAN PATENT APPLICATION**

(21) Application number: **86302227.3**

(22) Date of filing: **26.03.86**

(51) Int. Cl.⁴: **H 03 K 17/08**
**H 02 H 3/087**

(30) Priority: **01.04.85 US 718262**

(43) Date of publication of application:
**15.10.86 Bulletin 86/42**

(84) Designated Contracting States:
**DE FR GB**

(71) Applicant: **MOTOROLA, INC.**
**1303 East Algonquin Road**
**Schaumburg, Illinois 60196(US)**

(72) Inventor: **Rathke, William Michael**
**1311 South Highland Avenue**
**Arlington Heights Illinois 60005(US)**

(74) Representative: **Ibbotson, Harold et al,**
**Motorola Ltd Patent and Licensing Operations - Europe**
**Jays Close Viables Industrial Estate**
**Basingstoke Hampshire RG22 4PD(GB)**

(54) **Electronic circuit breaker.**

(57) An electronic circuit breaker for use with a controllable switch (11) that connects and disconnects power to and from a load. The electronic circuit breaker includes a sense unit (12) for sensing when current draw through said switch (11) exceeds a predetermined threshold, and for generating a fault signal in response to sensing such an excessive draw of current. The device further includes an inhibit unit (13) that can respond to such a fault signal to inhibit the switch unit (11) during the presence of such a fault signal. The device requires minimal heat sink provisions for the switch unit (11) and further serves to automatically re-enable the switch unit (11) such that a transient load fault condition will not require the attention of operating personnel to reset it.

*Fig. 2*

# ELECTRONIC CIRCUIT BREAKER

## Technical Field

This invention relates generally to circuit breakers, and more particularly to circuit breakers that are useful in power control circuits.

## Background Art

Electronic devices require power to operate. In certain instances, it becomes desirable to control the application of power as supplied to a specific device, such as a relay. In order to effectuate such control, an in line switch comprising a transistor has often been utilized. By appropriately controlling the biasing of this transistor, the controlled device can be selectively connected to and disconnected from a power source.

If a load short occurs during times when the controlled device connects through such a transistor to a power source, current draw through the transistor can increase and damage the circuit. In an attempt to resolve this situation, at least three prior art solutions have been proposed.

The simplest solution provides for a sensing mechanism to determine when current flow through the transistor equals or exceeds some preselected threshold, thereby providing an indicia of a load short condition. Upon sensing such a condition, this prior art solution provides that the transistor be biased off. Following this, no recovery of the system can occur in an automatic fashion. Rather, operator interaction must be resorted to. When the sensed load short condition only represents a transient condition, this inability to respond with an automatic recovery represents an undesirable characteristic of this solution.

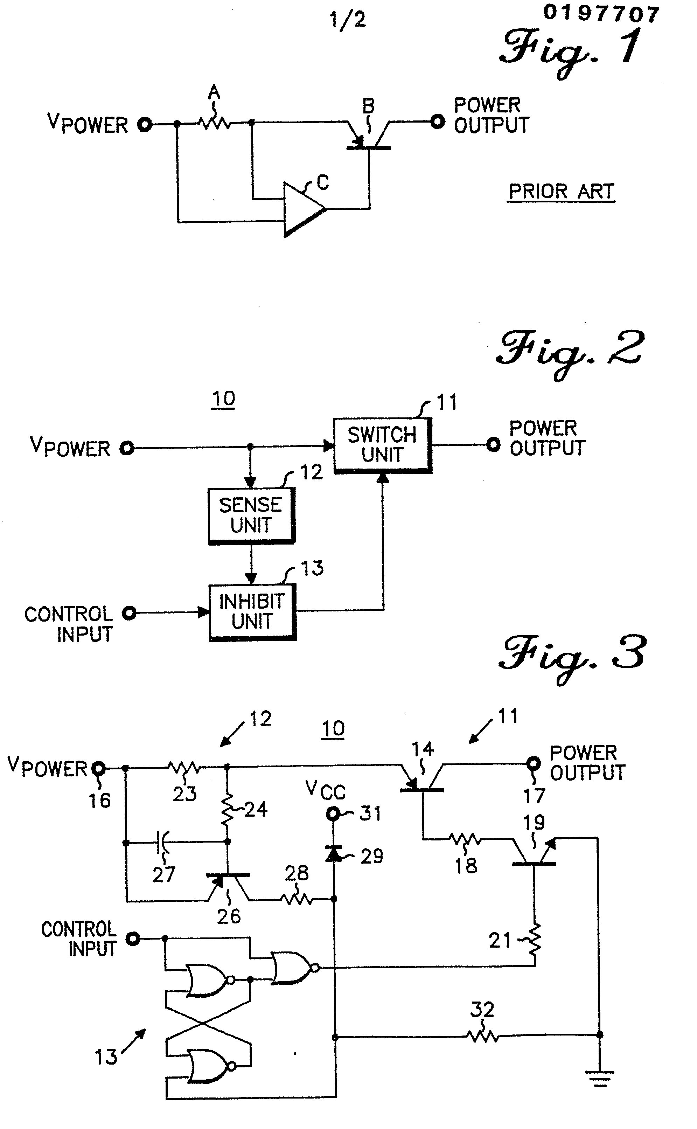

Referring to Fig. 1 of the drawings, a second prior art solution provides for a sense resistor (A) connected in series with the switch transistor (B). A comparator (C) of appropriate design connects across the sense resistor (A) and drives the base of the transistor (B) in response thereto. So configured, the comparator (C) operates to regulate the voltage across the sense resistor (A) by controlling base current to the transistor (B). In short, this prior art solution seeks to limit current flow through the transistor (B) under a load short condition.

This latter solution has the benefit of recovering automatically when a load short condition proves to be transient. Unfortunately, this solution also ensures that a non-negligible quantity of heat will be generated by the transistor (B) under load short conditions. Therefore, this solution requires that a significant amount of heat sink capability be provided. Further, it will be appreciated that this system does not constitute an energy efficient solution, since power will be consumed during non-transient load shorts.

The third prior art solution can also be described with reference to Fig. 1. Unlike the second prior art solution described above, however, this solution contemplates that the comparator (C) have at least two internal thresholds that may be switched depending upon the amplitude of the incoming signals. Therefore, if the voltage across the sense resistor becomes too high (an indicia of a load short condition), the comparator can switch to a lower internal threshold. This then aids in limiting the current flow through the transistor (B).

Furthermore, upon removal of the load short condition, the comparator can automatically revert back to the original threshold and continue to operate in an ordinary manner.

As with the second solution, this third solution has the benefit of automatically recovering in response to the removal of a load short condition. Unfortunately, although the heat problem with this solution is less than that experienced with the second solution noted above, a substantial heat sink must still be provided to effectuate this system, and power can still be wasted.

There therefore exists a need for an electronic circuit breaker that will protect a circuit from excessive current draw, generate little or no heat during the presence of a load short, and that can further recover normal operation once the load short condition has been resolved without requiring intervention of the operator.

Summary of Invention

The above needs are substantially met by provision of the electronic circuit breaker described in this specification. This electronic circuit breaker can be used with a system having a power input, a power output, and a switch positioned therebetween that can respond to a control signal for opening and closing a conductive path between the power input and the power output. The electronic circuit breaker includes a sense unit for sensing an excessive draw of current from the power input and for providing a fault signal when sensing such an excessive draw of current. The device further includes an inhibit unit that responds to the fault signal and inhibits the switch in the presence of such a signal to thereby cause the conductive path to be open.

In one embodiment of this invention, the switch can be realized through use of a transistor having its power terminals connected to the power input and the power output, respectively. The base of the transistor operably connects as appropriate to receive a control signal such that its switching state can be selectively determined.

The sense unit can be realized through use of a sense resistor placed in series with the power terminals of the transistor, and by use of a second switch, such as a transistor, that can respond to an increase in voltage across the resistor in order to produce a fault signal when current through the resistor exceeds a predetermined threshold.

The inhibit unit includes two inputs. One input receives the control signal and the remaining input receives the fault signal as generated by the sense unit. The inhibit unit further includes a flip-flop and an output stage. The control input provides the control signal to both the flip-flop and the output stage. The fault signal connects only to the reset port of the flip-flop.

So configured, the electronic circuit breaker operates to transmit unaltered "on" and "off" control signals to the transistor switch, presuming the absence of a fault signal. With a fault signal present, however, the inhibit unit will operate to inhibit the transmission of any "on" signals to the switch transistor.

More particularly, when current through the sense resistor exceeds some predetermined threshold, the sense unit transistor will switch on and cause an output fault signal to be applied at the reset port of the flip-flop in the inhibit unit. Then, regardless of whether the control signal input carries a high or low signal, the output control signal from the output stage will be drawn low. This, in turn, causes the switch transistor to be switched off.

Following this, current through the sense resistor will drop to zero, and the transistor associated therewith will switch off, thereby removing the fault signal from the reset port of the flip-flop. Therefore, the next "on" control signal that appears at the control input port of the inhibit unit will cause the switch transistor to switch on as usual. If the load short condition still exists, then the above described circuit breaker operation will again repeat. Otherwise, in the absence of a load short condition, the switch transistor will continue to operate in an ordinary fashion and the electronic circuit breaker will neither enhance nor inhibit this function.

This electronic circuit breaker optimally combines minimal heat generation and energy loss with a self enabling recovery feature, thereby gaining all of the benefits of prior art mechanisms without incurring the disadvantages associated therewith.

Brief Description of the Drawings

These and other attributes of the invention will become more clear upon making a thorough review and study of the following description of the best mode for carrying out the invention, particularly when reviewed in conjunction with the drawings, wherein:

Fig. 1 comprises a schematic diagram of a prior art solution;

Fig. 2 comprises a block diagram of an electronic circuit breaker as constructed in accordance with the invention;

Fig. 3 comprises a schematic diagram of the invention;

Fig. 4 comprises a schematic diagram of an illustrative load;

Fig. 5a comprises a schematic diagram of the inhibit unit for purposes of logic analysis;

Fig. 5b comprises a logic truth table for the configuration set forth in Fig. 5a; and

Fig. 6 comprises a waveform diagram of an illustrative control signal input.

## Best Mode for Carrying Out the Invention

Referring now to the drawings, and in particular to Fig. 2, the electronic circuit breaker can be seen as generally depicted in block diagram form by the numeral 10. The device (10) includes generally a switch unit (11), a sense unit (12), and an inhibit unit (13). These generally referred to components will now be described in more detail in seriatim fashion.

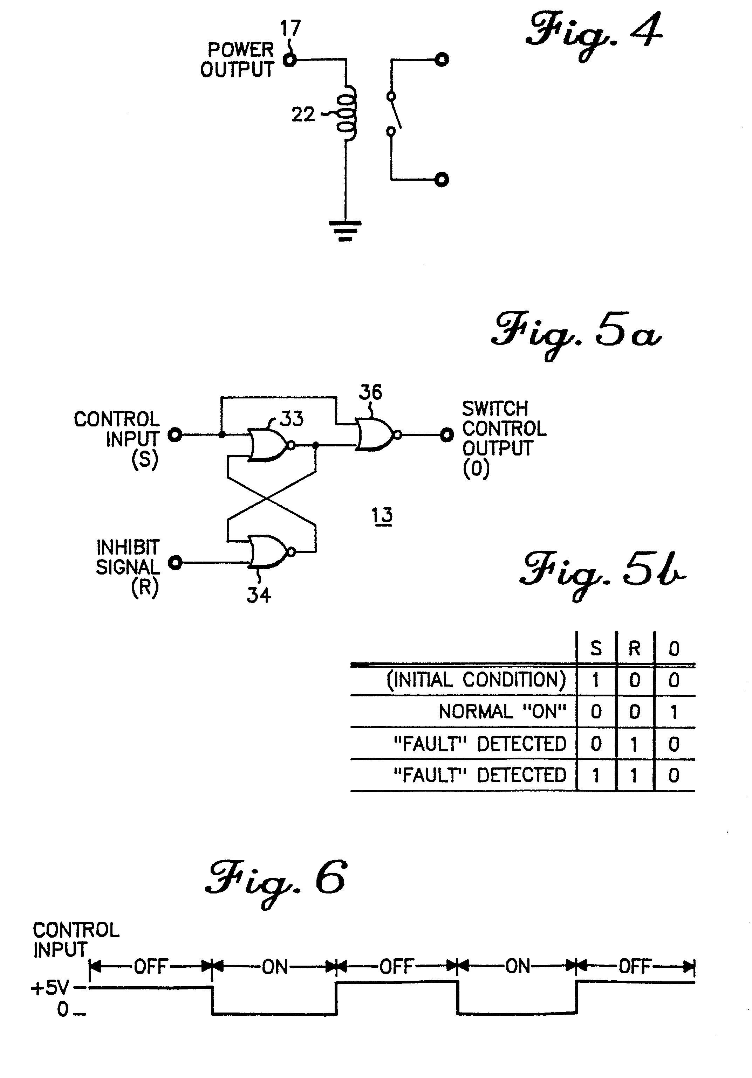

Referring now to Fig. 3, the switch unit (11) includes a first transistor (14) having its emitter operably connected through the sense unit (12) to a source of power (16), its collector connected to a power output port (17), and its base connected through a 1.8k ohm 1/2 watt resistor (18) to the collector of a second transistor (19). The first transistor may be provided through use of a TIPC106 transistor. The second transistor (19) (as may be provided through use of an MMBTA06 as manufactured by Motorola, Inc.) has its emitter connected to ground and its base connected through a 1k ohm resistor (21) to the output port of the inhibit unit (13) as described in more detail below.

So configured, a switch control signal as supplied to the base of the second transistor (19) will in turn switch on the first transistor (14) such that power may be supplied from the power source (16) to a load through the power output port (17). With reference to Fig. 4, such a load may be, for example, a relay (22).

Referring again to Fig. 3, the sense unit (12) includes a .1 ohm 1.5 watt resistor (23) connected in

series between the emitter of the first transistor (14) in the switch unit (11) and the power source (16). In addition, a 1k ohm resistor (24) connects the low side of the sense resistor (23) to the base of a third transistor (26) as may be provided through use of a Motorola MMBTA56. The base of this transistor (26) also connects through a .0047 microfarad capacitor (27) to the power source (16). The emitter of this transistor (26) connects to the power source (16) and the collector connects through a 1k ohm resistor (28) to the anode of a Motorola BAV70 diode (29), the cathode of which connects to a voltage supply (31) such as a 5 volt regulated source. The collector resistor (28) noted above also connects to the reset input port of the inhibit unit (13) as described below in more detail.

So configured, the sense unit (12) operates to switch on the third transistor (26) when current through the sense resistor (23) exceeds a threshold predetermined by the values of the components described above. When switched on, the third transistor (26) provides a fault signal output to the inhibit unit (13).

The inhibit unit (13) will now be described with reference to Fig. 5a. The inhibit unit (13) has been constructed about three two-input NOR gates (33, 34 and 36). The first two NOR gates (33 and 34) comprise a flip-flop and the third NOR gate (36) comprises an output stage.

One input of the first NOR gate (33) connects to the output of the second NOR gate (34), and similarly, one input of the second NOR gate (34) connects to the output of the first NOR gate (33). The remaining input of the first NOR gate (33) comprises a set input and operably connects to receive the control signals as intended for application to the switch unit (11). The remaining input to the second flip-flop (34) comprises a reset input and connects to receive the fault signal as provided by the sense unit (12).

The third NOR gate (36), comprising the output stage, has one input connected to receive the Q output of the flip-flop and its remaining input connected to directly receive the control signal.

With reference to Fig. 5b, it may be seen that an output signal can only be realized from the output stage NOR gate (36) by providing a low signal at both the set and reset input ports. If a logic high signal appears at either or both of the set or reset ports, then no output will be provided from the output stage. More particularly, it will be appreciated that so long as no fault signal appears at the reset port, then the output signal from the output stage will be the inverse of the control signal logic status. In the alternative, when a fault signal does appear at the reset port, then the output of the output stage will be inhibited regardless of the logic status of the control signal.

To take advantage of this particular configuration, a control signal may be utilized having a configuration such as that depicted in Fig. 6. It may be seen that this control signal provides an "on" signal by the presence of a logic low signal, whereas an "off" signal may be accommodated by transmission of a logic high signal. By use of such a control signal, an appropriate biasing signal will be transmitted by the inhibit unit (13) to the switch unit (11) by providing a logic low as the control signal (presuming that no fault signal is present). Similarly, an off signal can be supplied to the switch unit (11) by providing a logic high signal as the control signal.

By use of this electronic circuit breaker, the switch unit (11) will be turned off when a load short condition exists. By the same token, once the switch unit (11) has been switched off, the sense unit (12) will terminate transmission of a fault signal, and thereby

re-enable the inhibit unit (13) to transmit an on signal in conjunction with the control signal instructions. If the output fault condition has been remedied, then the switch unit (11) will have already recovered and will operate in its ordinary manner. If, however, the output fault condition persists, then the excessive draw of current will again be sensed by the sense unit (12), and the inhibit unit (13) will again be triggered to again inhibit the continued operation of the switch unit (14). Therefore, heat generation and energy dissipation can be minimized through use of this circuit. Further, the circuit provides for a self recovery mechanism that avoids the need for operator intervention.

Those skilled in the art will recognize various modifications and alterations that could be effectuated with respect to the described circuit that would not depart from the spirit of the invention. Therefore, the scope of the invention should not be viewed as being limited to the embodiment described, except as such limitations may be present in the claims themselves.

## Claims

1. In a system having a power input, a power output, and a switch that is responsive to a series of control signals having variable durations for opening and closing a conductive path between said power input and said power output, an improvement characterized by:

a) sense means for sensing an excessive draw of current from said power input and for providing a fault signal when sensing such an excessive draw of current; and

b) inhibit means responsive to said fault signal for inhibiting said switch in the presence of a fault signal only for the duration that remains of the control signal during which said sense means provides said fault signal, and for not inhibiting said switch in the absence of a fault signal.

2.   The improvement of claim 1 wherein said inhibit means is further responsive to said control signal.

3.   The improvement of claim 2 wherein said control signal is characterized by variable signal levels, with at least one of said signal levels representing an "on" signal and another of said signals representing an "off" signal, and wherein said inhibit means functions to block transmission of an "on" signal to said switch unit in the presence of a fault signal.

4.   The improvement of claim 3 wherein said inhibit means includes a flip-flop, such that a set input to said flip-flop operably receives said control signal and a reset input to said flip-flop operably receives said fault signal.

5.   The improvement of claim 4 wherein said inhibit means further includes an output stage comprising a NOR gate, with one input of said NOR gate connected to operably receive said control signal and a second input of said NOR gate connected to operably receive an output signal from said flip-flop.

6.   The improvement of claim 1 wherein said sense means includes a resistor connected in series with said switch means.

7.   The improvement of claim 6 wherein said sense means further includes a switch for generating said fault signal.

8.   The improvement of claim 7 wherein said sense means switch comprises a transistor.

9.    The improvement of claim 8 wherein said transistor has a collector that operably connects to said inhibit means to transmit said fault signal to said inhibit means.

10.    The improvement of claim 9 wherein said collector of said transistor also connects to a reverse biased diode.

Fig. 1

PRIOR ART

Fig. 2

Fig. 3

*Fig. 4*

*Fig. 5a*

*Fig. 5b*

| | S | R | 0 |
|---|---|---|---|
| (INITIAL CONDITION) | 1 | 0 | 0 |
| NORMAL "ON" | 0 | 0 | 1 |
| "FAULT" DETECTED | 0 | 1 | 0 |
| "FAULT" DETECTED | 1 | 1 | 0 |

*Fig. 6*